(19) Europäisches Patentamt / European Patent Office / Office européen des brevets

(11) **EP 3 935 399 B1**

(12) **EUROPÄISCHE PATENTSCHRIFT**

(45) Veröffentlichungstag und Bekanntmachung des Hinweises auf die Patenterteilung:
**07.06.2023  Patentblatt 2023/23**

(21) Anmeldenummer: **20709552.2**

(22) Anmeldetag: **05.03.2020**

(51) Internationale Patentklassifikation (IPC):
**G01R 29/16** *(2006.01)*    **G01R 31/42** *(2006.01)*
**G01R 31/62** *(2020.01)*    **G01R 19/25** *(2006.01)*

(52) Gemeinsame Patentklassifikation (CPC):
**G01R 31/62; G01R 19/2513;** G01R 29/16;
G01R 31/42; Y02E 10/56

(86) Internationale Anmeldenummer:
**PCT/EP2020/055818**

(87) Internationale Veröffentlichungsnummer:
**WO 2020/178377 (10.09.2020 Gazette 2020/37)**

(54) **VERFAHREN UND VORRICHTUNG ZUR NÄHERUNGSWEISEN BESTIMMUNG VON SPANNUNGEN AN EINER OBERSPANNUNGSSEITE EINES TRANSFORMATORS**

METHOD AND DEVICE FOR APPROXIMATELY DETERMINING VOLTAGES AT A HIGH-VOLTAGE SIDE OF A TRANSFORMER

PROCÉDÉ ET DISPOSITIF DE DÉTERMINATION APPROXIMATIVE DE TENSIONS SUR UN CÔTÉ DE SURTENSION D'UN TRANSFORMATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.03.2019  DE 102019105861**

(43) Veröffentlichungstag der Anmeldung:
**12.01.2022  Patentblatt 2022/02**

(73) Patentinhaber: **SMA Solar Technology AG**
**34266 Niestetal (DE)**

(72) Erfinder:
• **SAKSCHEWSKI, Vitali**
**34281 Gudensberg (DE)**
• **BUELO, Thorsten**
**34121 Kassel (DE)**
• **RAUSCHER, Florian**
**38118 Braunschweig (DE)**

(74) Vertreter: **Lahnor, Peter**
**SMA Solar Technology AG**
**Corporate Intellectual Property Management**
**Sonnenallee 1**
**34266 Niestetal (DE)**

(56) Entgegenhaltungen:
EP-A1- 3 442 106    WO-A1-2014/005619
WO-A1-2016/124443    US-B2- 8 949 054

**Beschreibung**

Die Erfindung betrifft ein Verfahren zur näherungsweisen Bestimmung von Spannungen an einer Oberspannungsseite eines Transformators anhand von gemessenen Spannungen an einer Unterspannungsseite des Transformators. Die Erfindung betrifft weiterhin eine Vorrichtung, insbesondere als Teil eines Wechselrichters, die zur Durchführung des genannten Verfahrens geeignet ist.

Wechselrichter werden in Energieversorgungsanlagen, beispielsweise Photovoltaikanlagen (PV-Anlagen) eingesetzt und dienen dort der Umwandlung von Gleichstrom in einen zur Einspeisung in ein Energieversorgungsnetz geeigneten netzkonformen Wechselstrom. Falls eine galvanische Trennung zwischen dem Energieversorgungsnetz und dem Wechselrichter gewünscht oder aufgrund von Richtlinien und gesetzlichen Bestimmungen für bestimmte Energieversorgungsnetze gefordert ist, ist zwischen einem Wechselstromausgang des Wechselrichters und dem Energieversorgungsnetz ein Transformator angeordnet.

Insbesondere bei größeren Photovoltaikanlagen, die unmittelbar an ein Mittelspannungsnetz angeschlossen werden, ist die Verwendung von Transformatoren unerlässlich. Gemäß beispielsweise der normativen Vorgabe "IEEE 1547" ist gefordert, dass Fehlerzustände des Energieversorgungsnetzes innerhalb der Energieversorgungsanlage detektiert werden können und die Energieversorgungsanlage nach Erkennung bestimmter Fehlerzustände auf diese reagiert und sich beispielsweise vom Netz trennt. Derartige Fehlerzustände sind z.B. Kurzschlüsse auf der Oberspannungsseite des Transformators. Konkret ist vorgesehen, dass ein Über- und/oder Unterschreiten von vorgegebenen Werten für die Leiter-Leiter-Spannungen (auch Dreiecksspannungen genannt) und/oder die Leiter-Erd-Spannungen (auch Strangspannungen genannt) detektiert wird, um auf Fehlerzustände zu schließen und das Einspeiseverhalten des Wechselrichters wie gefordert anzupassen. Dabei ist zu bedenken, dass bestimmte Transformatorenarten keinen Neutralleiter auf der Oberspannungsseite aufweisen oder diesen nicht zur Unterspannungsseite weiterleiten, wodurch keine Nullsystem-Spannung übertragen wird, was einen Informationsverlust darstellt.

Um die geforderte Änderung des Einspeiseverhaltens umsetzen zu können, ist Kenntnis der verschiedenen Leiter-Leiter-Spannungen, sowie der Leiter-Erd-Spannungen an der Oberspannungsseite des Transformators Voraussetzung.

Eine messtechnische Erfassung dieser Spannungen ist aufgrund des hohen Spannungsniveaus jedoch unter Umständen sehr aufwändig und kostenintensiv, beispielsweise wenn der Transformator an seiner Oberspannungsseite mit einem Mittelspannungsnetz mit Spannungen im Bereich von 20 kV (Kilovolt) verbunden ist. In einigen Netzsystemen ist es daher zulässig, das Einspeiseverhalten des Wechselrichters abhängig von Spannungsniveaus an der Unterspannungsseite des Transformators zu machen. Insbesondere bei Transformatorenarten, bei denen eine Nullsystem-Spannung nicht übertragen wird, spiegeln die Spannungsverhältnisse an der Unterseite des Transformators die Spannungsverhältnisse an der Oberspannungsseite des Transformators jedoch nur unzureichend wider. Eine unmittelbar anhand von Spannungsmessungen an der Unterspannungsseite des Transformators durchgeführte Fehlerbestimmung kann in dem Fall einen an der Oberspannungsseite des Transformators aufgetretenen Fehler nicht unbedingt korrekt detektieren. Für eine korrekte Fehlerdetektion ist eine möglichst genaue Kenntnis der Spannungsverhältnisse an der Oberspannungsseite des Transformators unerlässlich.

In dem Artikel "Characterization of Three-Phase Unbalanced Dips" von Bollen und Styvaktakis, IEEE, 2000 Power Engineering Society Summer Meeting (Cat. No.00CH37134), Seattle, WA, 2000, pp. 899-904, vol. 2, wird eine Methode beschrieben, mit der anhand von gemessenen Spannungen an einer Unterspannungsseite eines Transformators qualitative Aussagen über Fehlerzustände an der Oberspannungsseite des Transformators getroffen werden können. Nur qualitative Aussagen sind jedoch nicht geeignet, um konkrete Kriterien, die sich auf Spannungswerte an der Oberspannungsseite des Transformators beziehen, umzusetzen.

Die Druckschrift US 8949054 B2 offenbart ein Verfahren und System zur Bestimmung von Spannungen an einer Oberspannungsseite eines Transformators anhand von gemessenen Spannungen an einer Unterspannungsseite des Transformators, wobei eine Berechnung der Spannungsverhältnisse auf der Oberspannungsseite ausgehend von mit einem optischen Stromsensor gemessenen Strömen auf der Oberspannungsseite und den gemessenen Spannungen an der Unterspannungsseite unter Einbeziehung bekannter Eigenschaften des Transformators erfolgt.

Es ist eine Aufgabe der vorliegenden Erfindung, ein Verfahren und eine Vorrichtung bzw. ein Wechselrichter anzugeben, mit denen die Spannungsverhältnisse an einer Oberspannungsseite eines Transformators zuverlässig anhand der Spannungsverhältnisse an der Unterspannungsseite quantifiziert werden können, so dass eine Fehlerdetektion für die Oberspannungsseite des Transformators auch ohne eine messtechnische Erfassung der Spannungswerte an der Oberspannungsseite des Transformators erfolgen kann.

Diese Aufgabe wird gelöst durch ein Verfahren und einen Wechselrichter mit den Merkmalen des unabhängigen Anspruchs. Vorteilhafte Ausgestaltungen und Weiterbildungen sind Gegenstand der abhängigen Ansprüche.

Ein erfindungsgemäßes Verfahren der eingangs genannten Art weist die folgenden Schritte auf: Es werden Dreiecksspannungen, Strangspannungen und Phasenwinkel an der Unterspannungsseite des Transformators gemessen und die Strangspannungen und Phasenwinkel in Mit- und Gegensystemspannungen und Phasenwinkel des Mit- bzw. Gegensystems an der Unterspannungsseite transformiert. Dann werden Mit- und Gegensystemspannungen und Phasenwinkel des Mit- bzw. Gegensystems an der Oberspannungsseite aus den Mit- und Gegensystemspannungen und Phasenwinkeln des Mit- bzw. Gegensystems an der Unterspannungsseite bestimmt. Ein Schätzwert der Nullsystemspannung und ein Phasenwinkel eines Nullsystems an der Oberspannungsseite werden anhand der gemessenen Dreiecksspannungen, Strangspannungen und Phasenwinkel an der Unterspannungsseite bestimmt und durch Transformation die Mit-, Gegen- und Nullsystemspannungen und der Phasenwinkel in Strangspannungen und/oder Dreiecksspannungen an der Oberspannungsseite des Transformators bestimmt.

Spannungen an der Unterspannungsseite des Transformators sind beispielsweise die an Anschlüssen eines Wechselrichters, der über den Transformator mit einem Energieversorgungsnetz gekoppelt ist, anliegenden Spannungen. Entsprechend kann eine Vorrichtung, die zur Durchführung des erfindungsgemäßen Verfahrens eingerichtet ist, an Ausgangsanschlüssen eines Wechselrichters angeordnet sein oder auch in einen Wechselrichter integriert sein.

Das erfindungsgemäße Verfahren beruht auf der Grundidee, dass eine Bestimmung der Spannungen an der Oberspannungsseite in einem rotierenden Koordinatensystem vorteilhaft ist, da zwei von drei benötigten Spannungen, nämlich die des Mit- bzw. Gegensystems, sowie die zugehörigen Phasenwinkeln sich leicht aus den entsprechenden messbaren Werten der Unterspannungsseite ergeben. Somit braucht lediglich für die entsprechenden Parameter des Nullsystems eine Abschätzung erfolgen.

In einer vorteilhaften Ausgestaltung des Verfahrens werden die Mit- und Gegensystemspannungen an der Oberspannungsseite den Mit- bzw. Gegensystemspannungen an der Unterspannungsseite gleichgesetzt. Dabei kann optional ein Korrekturwert hinzuaddiert werden. Bevorzugt werden die Phasenwinkel des Mit- bzw. Gegensystems an der Oberspannungsseite aus den Phasenwinkeln an der Unterspannungsseite gesetzt, wobei ein Phasenkorrekturwert hinzuaddiert wird, der das n-fache von 30° für das Mitsystem und das n-fache von -30° für das Gegensystem beträgt. Dabei ist n ein ganzzahliger Wert, der von dem Typ des Transformators abhängt. Insbesondere wird der Wert von n abhängig von oder auch gleich einer Transformatorverschiebung des Transformators gewählt. Bis auf den genannten optionalen Korrekturwert für die Spannungen können die vier benötigten Spannungsparameter der Oberspannungsseite damit unmittelbar angegeben werden.

In einer weiteren vorteilhaften Ausgestaltung des Verfahrens wird zum Bestimmen eines Schätzwerts der Nullsystemspannung und des Phasenwinkels des Nullsystems an der Oberspannungsseite anhand der gemessenen Dreiecksspannungen und Strangspannungen an der Unterspannungsseite eine qualitative Fehlerbestimmung vorgenommen, durch die auf das Vorliegen eines Fehler an einer Phase oder mehrerer der Phasen der Oberspannungsseite geschlossen werden kann und durch die ein Erdschluss einer der Phasen der Oberspannungsseite erkannt werden kann. Hierbei wird zunächst nur qualitativ ermittelt, auf welcher Phase oder auf welchen Phasen ein Fehler vorliegt.

Vorteilhaft kann dabei auf an sich bekannte und etablierte Verfahren zurückgegriffen werden. Beispielsweise kann zur qualitativen Fehlerbetrachtung aus den gemessenen Dreiecksspannungen und Strangspannungen eine minimale Spannung ermittelt werden, wobei ein Vergleich der gemessenen Dreiecksspannungen und Strangspannungen mit der minimalen Spannung auf eine fehlerbehaftete Phase an der Oberspannungsseite schließen lässt. Weiter kann zur qualitativen Fehlerbestimmung aus den gemessenen Dreiecksspannungen und Strangspannungen eine maximale Spannung ermittelt wird, wobei ein Vergleich der maximalen Spannung mit einem Vergleichswert, der charakteristisch ist für das oberspannungsseitige Netz, mit dem der Transformator verbunden ist, auf einen Erdschluss an der Oberspannungsseite schließen lässt. Der Vergleichswert kann dabei abhängig von einer subtransienten Kurzschlussleistung des Netzes gewählt werden.

Im Ergebnis kann anhand dieser qualitativen Fehlerbetrachtung ermittelt werden, ob ein einpoliger oder ein zweipoliger Kurzschluss an der Oberspannungsseite vorliegt und/oder ob ein einpoliger oder ein zweipoliger Erdschluss vorliegt.

Eine folgende Abschätzung von Parametern des Nullspannungssystems kann auf der Basis eines solchen Ergebnisses der qualitativen Fehlerbetrachtung mit höherer Qualität erfolgen. So wird vorteilhaft beim Vorliegen eines einpoligen Erdschlusses der Wert für die Nullsystemspannung an der Oberspannungsseite gleich dem Produkt der Gegensystemspannung und der Wurzel der Mitsystemspannung gesetzt. Beim Vorliegen eines zweipoligen Kurzschlusses wird der Wert für die Nullsystemspannung an der Oberspannungsseite gleich null gesetzt. Beim Vorliegen eines zweipoligen Erdschlusses wird dagegen der Wert für die Nullsystemspannung an der Oberspannungsseite gleich dem Quotienten des Quadrats der Gegensystemspannung und der Mitsystemspannung gesetzt.

In einer weiteren vorteilhaften Ausgestaltung des Verfahrens wird der Wert für den Phasenwinkel im Nullsystem an der Oberspannungsseite gleich dem Phasenwinkel im Gegensystem an der Oberspannungsseite gesetzt, zuzüglich eines Phasenoffsets, der 0°, 120° oder -120° beträgt, abhängig davon, auf welche Phase an der Oberspannungsseite der qualitativ bestimmte Fehler vorliegt.

Die Erfindung wird nachfolgend anhand von einem Ausführungsbeispiel mit Hilfe von Figuren näher erläutert. Die Figuren zeigen:

Fig. 1 eine schematische Darstellung einer an ein Energieversorgungsnetz angeschlossene PV-Anlage;

Fig. 2 ein schematischer Ablaufplan eines Ausführungsbeispiels eines anmeldungsgemäßen Verfahrens; und

Fig. 3 ein Blockschaltbild eines Wechselrichters mit einer integrierten anmeldungsgemäßen Vorrichtung.

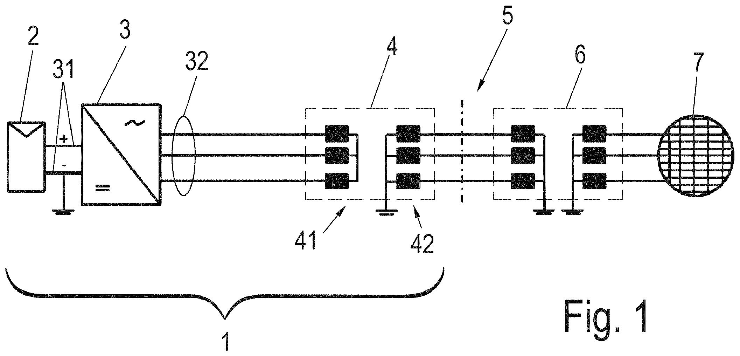

Fig. 1 zeigt in einem Blockschaltbild eine PV-Anlage 1 als ein Beispiel einer dezentralen Energieversorgungsanlage. Die PV-Anlage 1 umfasst einen PV-Generator 2, der über einen Gleichstromeingang 31 an einen Wechselrichter 3 angeschlossen ist. Der Wechselrichter 3 ist über Wechselstromausgänge 32 mit einer Primärseite 41 eines Transformators 4 verbunden. Der Transformator 4 ist im dargestellten Beispiel ein Mittelspannungstransformator, der an seiner Sekundärseite 42 Spannungen im Bereich von etwa 20 kV bereitstellt und entsprechend mit einem Mittelspannungsnetz 5 als Energieversorgungsnetz verbunden ist.

Die Struktur der PV-Anlage 1 ist in der Fig. 1 beispielhaft und vereinfacht dargestellt. Der in der Fig. 1 nur durch das Schaltsymbol einer PV-Zelle symbolisierte PV-Generator 2 umfasst bei einer unmittelbar in das Mittelspannungsnetz 5 einspeisenden PV-Anlage 1 üblicherweise eine Vielzahl von PV-Modulen, von denen jeweils mehrere zu sogenannten PV-Strings serienverschaltet sind, die wiederum jeweils parallel geschaltet mit dem Wechselrichter 3 verbunden sind. Der Wechselrichter 3 ist bei Anlagen dieser Art üblicherweise als ein Zentralwechselrichter ausgebildet. Der Wechselrichter 3 ist im dargestellten Beispiel dreiphasig ausgeführt, wie es in Verbindung mit Mittelspannungsnetzen 5 üblich ist. In der Fig. 1 sind lediglich die im Rahmen der Anmeldung wesentlichen Teile der PV-Anlage 1 dargestellt. Weitere gleich- oder wechselstromseitig vom Wechselrichter 3 angeordnete Elemente, wie zum Beispiel Trenn- oder Schaltorgane, Filter oder Überwachungseinrichtungen, sind aus Gründen der Übersichtlichkeit nicht dargestellt.

Üblicherweise entfernt von der PV-Anlage 1 ist im weiteren Verlauf des Mittelspannungsnetzes 5 ein (Hochspannungs-)Transformator 6 vorgesehen, über den die Mittelspannungsebene 5 mit einem Hochspannungsnetz 7 verbunden ist, das als übergeordnetes Energieversorgungsnetz dient.

Durch die galvanische Trennung der Primärseite 41 des Transformators 4 von der Sekundärseite 42 kann eine häufig von Betreibern des Energieversorgungsnetzes 7 geforderte separate Erdung der PV-Anlage 1 erfolgen, hier beispielhaft indem ein negativer Pol des PV-Generators 2 mit einem Erdpotential verbunden ist.

Der Transformator 4 weist unterspannungsseitig, an seiner mit dem Wechselrichter 3 verbundenen Primärseite 41 Wicklungen in einer sternförmigen Verschaltung auf. Ein Nullleiteranschluss ist unterspannungsseitig nicht herausgeführt. Auf der Sekundärseite 42 an der Oberspannungsseite des Transformators sind die Wicklungen ebenfalls sternförmig verschaltet, wobei ein Nullleiteranschluss separat herausgeführt ist und als Erdungsanschluss dient. Der Transformator 4 ist somit ein YNy-Transformator.

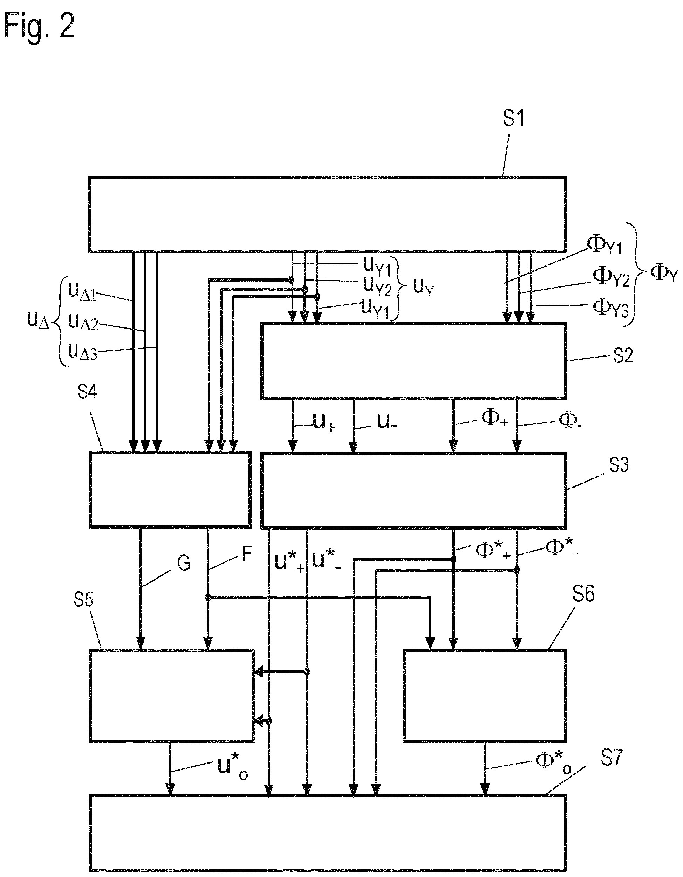

Um Erfordernisse in Hinblick auf eine Fehlererkennung im Mittelspannungsnetz 5 umsetzen zu können, ist anmeldungsgemäß vorgesehen, aus gemessenen Spannungen an der Unterspannungsseite (Primärseite 41) des Transformators 4 Spannungen an der Oberspannungsseite (Sekundärseite 42) durch eine Schätzung zu ermitteln. Die Spannungen an der Primärseite 41 des Transformators 4 können beispielsweise im Bereich der transformatorseitigen Anschlüsse des Wechselrichters 3 gemessen werden. Ein für die Schätzung der Spannungen an der Oberspannungsseite geeignetes anmeldungsgemäßes Verfahren ist in Fig. 2 in Form eines Ablaufplans dargestellt. Beispielhaft wird das Verfahren anhand der PV-Anlage gemäß Fig. 1 erläutert.

In einem ersten Schritt S1 werden Spannungen am Wechselstromausgang 32 des Wechselrichters 3 und damit an der Unterspannungsseite des Transformators 4 gemessen. Konkret sind dieses die sogenannten Dreiecksspannungen $u_\Delta$ zwischen zweien der Leiter (nachfolgend auch Phasen genannt), sowie Strangspannungen $u_Y$ zwischen einem Leiter und einem (künstlich) Nullleiter sowie mit diesen Strangspannungen verbundene Phasenwinkel $\Phi_Y$. Konkret werden drei Dreiecksspannungen $u_\Delta$ gemessen, eine erste Dreieckspannung $u_{\Delta 12}$ zwischen einer ersten und zweiter Phase, eine zweite Dreiecksspannung $u_{\Delta 23}$ zwischen der zweiten und einer dritten Phase und eine dritte Dreiecksspannung $u_{\Delta 31}$ der dritten und der ersten Phase. Wenn nachfolgend von den Dreieckspannungen $u_\Delta$ gesprochen wird, sind die drei genannten Spannungen umfasst.

Die Strangspannungen $u_Y$ umfassen ebenfalls drei Spannungswerte, nämlich eine erste Strangspannung $u_{Y1}$, die zwischen der ersten Phase und dem künstlichen Nullleiter gemessen wird, eine zweite Strangspannung $u_{Y2}$, die zwischen der zweiten Phase und dem künstlichen Nullleiter gemessen wird und eine dritte Strangspannung $u_{Y3}$, die zwischen der dritten Phase und dem künstlichen Nullleiter gemessen wird. Wiederum werden nachfolgend unter den Strangspannungen $u_Y$ die drei genannten Werte verstanden. Als künstlicher Nullpunkt kann beispielsweise ein Knoten angesehen werden, der über drei gleiche Widerstände mit den drei Phasen verbunden ist.

Auch die Phasenwinkel $\Phi_Y$ umfassen drei Werte, einen ersten Phasenwinkel $\Phi_{Y1}$, der eine Phasenlage der ersten Strangspannung $u_{Y1}$ angibt, einen zweiten Phasenwinkel $\Phi_{Y2}$, der eine Phasenlage der zweiten Strangspannung $u_{Y2}$ angibt, und einen dritten Phasenwinkel $\Phi_{Y3}$, der eine Phasenlage der dritten Strangspannung $u_{Y3}$ angibt.

In einem Schritt S2 wird eine Transformation der gemessenen zeitabhängigen Spannungsmesssignale, die sich in den Strangspannungen $u_Y$ und den Phasenwinkeln $\Phi_Y$ darstellen, in ein rotierendes Koordinatensystem vorgenommen. Die Darstellung der Messgrößen in dem rotierenden Koordinatensystem erfolgt in bekannter Form eines Mitspannungssystems und eines Gegenspannungssystems, das jeweils in Betrag und Phase komplex angegeben wird. In dem Schritt S2 werden somit aus den genannten Eingangsgrößen der Strangspannungen $u_Y$ und den Phasenwinkeln $\Phi_Y$ ein Mitsystemspannungsbetrag u+ und ein Mitsystemspannungsphasenwinkel $\Phi_+$ bestimmt. Weiter werden ein Gegensystemspannungsbetrag u_ und ein Gegensystemspannungsphasenwinkel $\Phi_-$ ermittelt.

Die vier in Schritt S2 ermittelten Werte werden in einem nächsten Schritt S3 in entsprechende Werte auf der Oberspannungsseite (Sekundärseite 42) des Transformators 4 umgesetzt. Nachfolgend sind Spannungswerte, die sich auf die Oberspannungsseite des Transformators beziehen, durch einen hochgestellten Stern (*) gekennzeichnet.

Die Umsetzung der symmetrischen Komponenten (d.h. der Mitsystem- und der Gegensystemkomponenten) der Unterspannungsseite auf die Oberspannungsseite basiert in einer Ausgestaltung auf der Annahme, dass sich die Beträge der Mitsystem- und Gegensystemspannungen zwischen Unterspannungsseite und Oberspannungsseite des Transformators nicht ändern. In einer Weiterbildung können dabei Korrekturwerte c+ bzw. c- für das Mit- und das Gegensystem berücksichtigt werden. Es ergibt sich damit für die Mit- bzw. Gegensystemspannungen auf der Oberspannungsseite:

$$u_+{}^* = u_+ + c_+$$

$$u_-{}^* = u_- + c_-$$

Je nach Schaltungstopologie des Transformators unterscheiden sich Phasenwinkel $\Phi^*_+$ bzw. $\Phi^*_-$ auf der Oberspannungsseite des Transformators von den entsprechenden Phasenwinkeln $\Phi_+$ bzw. $\Phi_-$ um eine Anzahl von n Vielfachen von 30°. Die Größe n ist dabei von der Schaltungstypologie des Transformators abhängig und wird auch als Trafoverschiebung bezeichnet. Damit ergibt sich:

$$\Phi^*_+ = \Phi_+ + n \cdot 30°$$

$$\Phi^*_- = \Phi_- - n \cdot 30°$$

In einem nächsten Schritt S4, der zeitlich gesehen parallel oder im Wesentlichen parallel zu den Schritten S2 und S3 ausgeführt werden kann, wird ausgehend von den Dreiecksspannungen $u_\Delta$ und den Strangspannungen $u_Y$ ein qualitativer Hinweis auf einen Fehler auf der Oberspannungsseite ermittelt. Der Schritt S4 dient dabei nicht einer unmittelbaren Fehlerangabe eines möglicherweise auf der Oberspannungsseite vorliegenden Fehlers, sondern wird durchgeführt, um die Abschätzung von Spannungen an der Oberspannungsseite des Transformators, die letztlich zu Fehlererkennung herangezogen werden, zu ermöglichen. Dieses wird detaillierter im Zusammenhang mit den Schritten S5 und S6 ausgeführt.

Im Schritt S4 wird qualitativ ermittelt, ob ein Fehler bei einer der oberspannungsseitigen Phasen vorliegt und es wird erfasst, ob der beobachtete Fehler ein Erdschlussfehler ist. Abhängig von dem Ergebnis in Schritt 4 wird eine Information F ermittelt, die angibt, ob und auf welcher Phase oder auf welchen Phasen ein Fehler vorliegt. Weiter wird eine Information G ermittelt, die einen Erdschluss anzeigt. Diese Signale bzw. Werte werden nachfolgend als Fehlerinformationen F, G bezeichnet. Die Fehlerinformationen F und G werden zur weiteren Bearbeitung in einem Schritt S5 benötigt, die Fehlerinformation F zusätzlich in einem weiteren Schritt S6.

In einer vorteilhaften Ausgestaltung des Verfahrens wird zur Bestimmung der Fehlerinformationen F, G eine Vorgehensweise verwendet, die sich an den eingangs genannten Artikel von Bollen und Styvaktakis, IEEE, 2000 Power Engineering Society Summer Meeting (Cat. No.00CH37134), Seattle, WA, 2000, pp. 899-904, vol. 2 orientiert. Konkret wird zur Bestimmung des Fehlersignals F ein minimaler Spannungsbetrag $V_{min}$ und ein maximaler Spannungsbetrag $V_{max}$ unter den Dreiecksspannungen $u_\Delta$ und den Strangspannungen $u_Y$ bestimmt. Weiter wird die Information benötigt, welcher Transformatorentyp oberspannungsseitig vorliegt.

Entspricht der minimale Spannungsbetrag $V_{min}$ der ersten Strangspannung $u_{Y1}$, liegt auf der Oberspannungsseite bei einem Y-Trafo ein Fehler auf der ersten Phase und bei einem D-Trafo ein Fehler der ersten Dreiecksspannung vor. Entspricht der minimale Spannungsbetrag $V_{min}$ der zweiten Strangspannung $u_{Y2}$, liegt auf der Oberspannungsseite bei einem Y-Trafo ein Fehler auf der zweiten Phase und bei einem D-Trafo ein Fehler der zweiten Dreiecksspannung vor. Entspricht der minimale Spannungsbetrag $V_{min}$ der dritten Strangspannung $u_{Y3}$, liegt auf der Oberspannungsseite bei einem Y-Trafo ein Fehler auf der dritten Phase und bei einem D-Trafo ein Fehler der dritten Dreiecksspannung vor. Die Definitionen von Strang- und Dreiecksspannungen auf der Oberspannungsseite sind dabei analog zu denen auf der Unterspannungsseite.

Entspricht dagegen der minimale Spannungsbetrag $V_{min}$ der ersten Dreiecksspannung $u_{\Delta12}$, liegt auf der Oberspannungsseite bei einem D-Trafo ein Fehler auf der zweiten Phase und bei einem Y-Trafo ein Fehler der ersten Dreiecksspannung vor. Entspricht der minimale Spannungsbetrag $V_{min}$ der zweiten Dreiecksspannung $u_{\Delta23}$, liegt auf der Oberspannungsseite bei einem Y-Trafo ein Fehler auf der dritten Phase und bei einem D-Trafo ein Fehler der zweiten Dreiecksspannung vor. Entspricht der minimale Spannungsbetrag $V_{min}$ der dritten Dreiecksspannung $u_{\Delta 31}$, liegt auf der Oberspannungsseite bei einem Y-Trafo ein Fehler auf der ersten Phase und bei einem D-Trafo ein Fehler der dritten Dreiecksspannung vor.

Ebenfalls der Methode von Bollen folgend kann ein Erdschluss ermittelt werden, indem der maximal aufgetretene Spannungsbetrag $V_{max}$ mit einem sogenannten "ground indicator" GI verglichen wird. Liegt der Spannungsbetrag $V_{max}$ unter dem Wert GI wird auf einen Erdschluss geschlossen. Die Größe des *ground indicators* GI ist abhängig von einer subtransienten Kurzschlussleistung des Netzes, an das der Transformator mit seiner Oberspannungsseite angebunden ist.

In nachfolgenden Schritten S5 und S6 werden aus den bislang bestimmten und als Ergebnis der Schritte S3 und S4 vorliegenden Parametern ein Betrag der Nullspannung im Nullspannungssystem $u^*_0$ auf der Oberspannungsseite (Schritt S5) und eine Phase $\Phi^*_0$ auf der Oberspannungsseite des Nullsystems (Schritt S6) bestimmt.

Im Schritt S5 werden dazu die Fehlerinformationen F, G sowie die Spannungen $u^*_-$ und $u^*_-$ des Mit- und Gegensystems der Oberspannungsseite benötigt. Dazu wird anmeldungsgemäß die folgende Rechenvorschrift eingesetzt:

$$u^*_0 = u^*_- \cdot f,$$

wobei der Faktor f abhängig von der Art des im Schritt S4 ermittelten Fehlers ist. Der Faktor f ist dabei gleich $(u^*_+)^{1/2}$ (also Wurzel aus $u^*_+$), wenn es sich um einen einpoligen Erdschluss handelt, gleich 0, wenn es sich umso einen zweipoligen Kurzschluss handelt, und gleich $u^*_- / u^*_+$, wenn es sich um einen zweipoligen Erdschlussfehler handelt.

Falls in dem Schritt S4 eine genaue Fehlerbestimmung nicht möglich war, so wird der Betrag des Nullsystems $u^*_0$ auf 0 gesetzt und damit grundsätzlich wie ein zweipoliger Kurzschluss behandelt.

In einem Schritt S6 wird in ähnlicher Weise wie im Schritt S5 der Phasenwinkel $\Phi^*_0$ des Nullsystems auf der Oberspannungsseite anhand von zuvor berechneten Größen sowie der Fehlerinformation F ermittelt. Dabei ergibt sich der Phasenwinkel $\Phi^*_0$ wie folgt:

$$\Phi^*_0 = \Phi^*_- + \Delta\Phi,$$

wobei $\Delta\Phi$ ein Phasenoffset ist, der 0° beträgt, wenn ein Fehler auf der ersten Phase der Oberspannungsseite des Transformators vorliegt oder an der ersten Dreiecksspannung zwischen der ersten und zweiten Phase an der Oberspannungsseite. Der Phasenoffset $\Delta\Phi$ beträgt 120°, wenn der Fehler an der zweiten Phase oder der zweiten Dreiecksspannung zwischen der zweiten und der dritten Phase der Oberspannungsseite vorliegt. Schließlich beträgt der Phasenoffset $\Delta\Phi$ beträgt -120°, wenn der Fehler an der dritten Phase oder der dritten Dreiecksspannung zwischen der dritten und der ersten Phase vorliegt.

Nach Durchführung der Schritte S5 und S6 liegt mit den Ergebnissen dieser Schritte sowie dem Ergebnis aus Schritt S3 ein vollständig die Spannungsverhältnisse auf der Oberspannungsseite des Transformators beschreibendes Mit-, Gegen- und Nullsystem (jeweils in Betrag und Phasenlage) vor. Aus den entsprechenden Werten $u^*_+$, $u^*_-$, $u^*_0$ und $\Phi^*_+$, $\Phi^*_-$, $\Phi^*_0$ werden in einem abschließenden Schritt S7 die einzelnen Spannungen an der Oberspannungsseite des Transformators durch eine entsprechende Rücktransformation aus dem rotierenden in ein statisches Bezugssystem berechnet.

Die so berechneten Spannungen können in nachfolgenden, hier nicht näher dargestellten Schritten verwendet werden, um zu überprüfen, ob an der Oberspannungsseite des Transformators Netzfehler vorliegen, auf die der Wechselrichter gemäß vorgegebener Richtlinien zu reagieren hat, beispielsweise indem eine Einspeisung in das Energieversorgungsnetz gestoppt oder bezüglich einer eingespeisten Leistung oder eines fließenden Stroms reduziert wird.

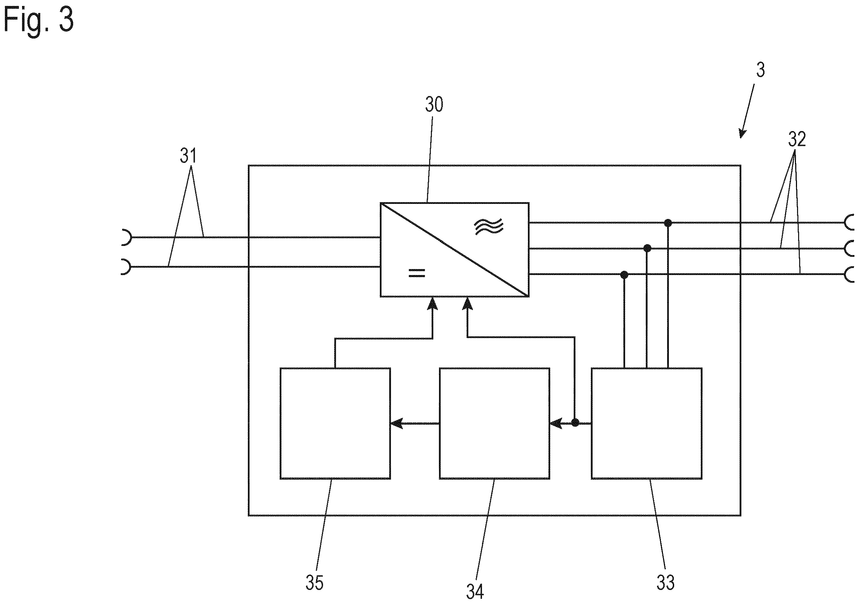

Fig. 3 zeigt in Form eines Blockschaltbilds ein Ausführungsbeispiel eines Wechselrichters 3 mit einer integrierten Vorrichtung zur Schätzung von Spannungen an einer Oberspannungsseite eines Transformators.

Der in Fig. 3 gezeigte Wechselrichter 3 kann beispielsweise in der in Fig. 1 dargestellten Energieversorgungsanlage eingesetzt werden. Er umfasst als eine Hauptkomponente einen DC/AC-Wandler 30, der die Hauptfunktionalität, das Umsetzen eines eingangsseitig an Gleichstromeingängen 31 zugeführten Gleichstroms (direct current - DC) in einen ausgangsseitig an einem Wechselstromausgang 32 bereitgestellten Wechselstroms (alternating current - AC). Wie beim Beispiel der Fig. 1 ist der hier dargestellte Wechselrichter 3 3-phasig ausgebildet.

Der Wechselrichter 3 umfasst weiterhin eine Spannungsmess- und -transformationseinheit 33, die mit den Wechselspannungsausgängen 32 verbunden ist. Diese Verbindung ermöglicht es der Spannungsmess- und -transformationseinheit 33 die an einer Unterspannungsseite eines mit dem Wechselstromausgang 32 verbundenen Transformators (vgl. Fig. 1) anliegenden Spannungen und Phasenlagen wie in Zusammenhang mit dem Schritt S1 der Fig. 2 beschrieben ist, zu messen. Dabei können sowohl die Dreiecksspannungen $U_\Delta$ als auch die Strangspannungen $U_Y$ gemessen werden. Es ist auch möglich, nur die Strangspannungen $U_Y$ einschließlich entsprechender Phasenwinkel $\Phi_Y$ zu messen und daraus die Dreiecksspannungen $U_\Delta$ zu ermitteln.

Innerhalb der Spannungsmess- und -transformationseinheit 33 erfolgt auch die in Schritt S2 der Fig.

2 angegebene Transformation der Strangspannungen $U_Y$ bzw. Phasenwinkel $\Phi_Y$ in entsprechende Werte eines Mitspannungssystems und eines Gegenspannungssystems.

Die gemessenen und transformierten Werte werden einer Verarbeitungseinheit 34 übergeben, die die in Zusammenhang mit den Schritten S3-S6 der Fig. 2 angegebenen Verarbeitungsschritte ausführt. Die in diesen Schritten ermittelten Werte werden von der Verarbeitungseinheit 34 an eine Rücktransformationseinheit 35 übergeben, die die Rücktransformation in Spannungswerte eines stationären Systems gemäß dem Schritt S7 durchführt.

Die so berechneten Schätzwerte von Spannungen an der Oberspannungsseite des Transformators werden einer Steuereinheit des DC/AC-Wandlers 30 übergeben, der sein Einspeiseverhalten entsprechend der berechneten Werte anpassen kann, beispielsweise in dem eine Einspeisung in das Energieversorgungsnetz gestoppt oder bezüglich einer eingespeisten Leistung oder eines fließenden Stroms reduziert wird, wenn die berechneten Spannungswerte der Oberspannungsseite des Transformators auf Netzfehler hindeuten.

Die von der Spannungsmess- und -transformationseinheit 33 bestimmten Werte können zusätzlich auch der Steuereinrichtung des DC/AC-Wandlers 30 übertragen werden, da diese Werte in der Regel im Rahmen eines pulsweiten Modulationsverfahrens zu Generierung der sinusförmigen Ausgangsspan-nungen bzw. sinusförmige Ausgangsströme vom DC/AC-Wandler benötigt werden.

**Bezugszeichen**

1 PV-Anlage
2 PV-Generator
3 Wechselrichter
4 Transformator
5 Mittelspannungsnetz
6 Hochspannungstransformator
7 Hochspannungsnetz

30 DC/AC-Wandler
31 Gleichstromeingang
32 Wechselstromausgang
33 Spannungsmess- und Transformationseinheit
34 Verarbeitungseinheit
35 Rücktransformationseinheit

$u_\Delta$ Dreiecksspannungen (Unterspannungsseite)
$u_{\Delta12}$ erste Dreiecksspannung (Unterspannungsseite)
$u_{\Delta23}$ zweite Dreiecksspannung (Unterspannungsseite)
$u_{\Delta31}$ dritte Dreiecksspannung (Unterspannungsseite)

$u_Y$ Strangspannungen (Unterspannungsseite)

$u_{Y1}$ erste Strangspannung (Unterspannungsseite)
$u_{Y2}$ zweite Strangspannung (Unterspannungsseite)
$u_{Y3}$ dritte Strangspannung (Unterspannungsseite)

$\Phi_Y$ Phasenwinkel (Unterspannungsseite)
$\Phi_{Y1}$ erster Phasenwinkel (Unterspannungsseite)
$\Phi_{Y2}$ zweiter Phasenwinkel (Unterspannungsseite)
$\Phi_{Y3}$ dritter Phasenwinkel (Unterspannungsseite)

$u+$ Mitsystemspannungsbetrag (Unterspannungsseite)
$u_-$ Gegensystemspannungsbetrag (Unterspannungsseite)
$\Phi_+$ Phasenwinkel Mitsystem (Unterspannungsseite)
$\Phi_-$ Phasenwinkel Gegensystem (Unterspannungsseite)

$u*+$ Mitsystemspannungsbetrag (Oberspannungsseite)
$u*_-$ Gegensystemspannungsbetrag (Oberspannungsseite)
$u*_0$ Nullsystemspannungsbetrag (Oberspannungsseite)

$\Phi*_+$ Phasenwinkel Mitsystem (Oberspannungsseite)
$\Phi*_-$ Phasenwinkel Gegensystem (Oberspannungsseite)
$\Phi*_0$ Phasenwinkel Nullsystem (Oberspannungsseite)

n Anzahl (der Phasenverschiebungen um 30°)
c+, c- Korrekturwert
F, G Fehlerinformation
f Faktor
$\Delta\Phi$ Phasenoffset

Vmin, Vmax minimale bzw. maximale Spannung

S1-S7 Verfahrensschritt

**Patentansprüche**

1. Verfahren zur näherungsweisen Bestimmung von Spannungen an einer Oberspannungsseite eines Transformators (4) anhand von gemessenen Spannungen an einer Unterspannungsseite des Transformators (4), mit den folgenden Schritten:

- Messen von Dreiecksspannungen ($u_\Delta$) und Strangspannungen ($u_Y$) und Phasenwinkeln ($\Phi_Y$) an der Unterspannungsseite des Transformators (4);
- Transformieren der Strangspannungen ($u_Y$) und Phasenwinkel ($\Phi_Y$) in Mit- und Gegensystemspannungen ($u_+$, $u_-$) und Phasenwinkel ($\Phi_+$, $\Phi_-$) des Mit- bzw. Gegensystems an der Unterspannungsseite;
- Bestimmen von Mit- und Gegensystemspannungen ($u^*_+$, $u^*_-$) und Phasenwinkeln ($\Phi^*_+$, ($\Phi^*_-$)) des Mit- bzw. Gegensystems an der Oberspannungsseite aus den Mit- und Gegensystemspannungen ($u_+$, $u_-$) und Phasenwinkeln ($\Phi_+$, $\Phi_-$) des Mit- bzw. Gegensystems an der Unterspannungsseite;

- Bestimmen von Schätzwerten einer Nullsystemspannung ($u^*_0$) und eines Phasenwinkels ($\Phi^*_0$) eines Nullsystems an der Oberspannungsseite aus den gemessenen Dreiecksspannungen ($u_\Delta$) und Strangspannungen ($u_Y$) und Phasenwinkeln ($\Phi_Y$) an der Unterspannungsseite;

- Transformieren der Mit-, Gegen- und Nullsystemspannungen ($u^*_+$, $u^*_-$, $u^*_0$) und der Phasenwinkel ($\Phi^*_+$, $\Phi^*_-$, $\Phi^*_0$) in Strangspannungen und/oder Dreiecksspannungen an der Oberspannungsseite des Transformators (4).

2. Verfahren nach Anspruch 1, bei dem die Mit- und Gegensystemspannungen ($u^*+$, $u^*-$) an der Oberspannungsseite gleich den Mit- bzw. Gegensystemspannungen ($u+$, $u-$) an der Unterspannungsseite gesetzt werden.

3. Verfahren nach Anspruch 2, bei dem zu den Mit- bzw. Gegensystemspannungen ($u+$, $u-$) ein Korrekturwert ($c-$, $c-$) hinzuaddiert wird, um die Mit- und Gegensystemspannungen ($u^*+$, $u^*_-$) zu bestimmen.

4. Verfahren nach einem der Ansprüche 1 bis 3, bei dem die Phasenwinkel ($\Phi^*_+$, ($\Phi^*_-$) des Mit- bzw. Gegensystems an der Oberspannungsseite aus den Phasenwinkeln ($\Phi_+$, $\Phi_-$) an der Unterspannungsseite gesetzt werden, wobei ein Phasenkorrekturwert hinzuaddiert wird, der das n-fache von 30° für das Mitsystem und das n-fache von -30° für das Gegensystem beträgt, und wobei n ein ganzzahliger Wert ist, der von dem Typ des Transformators (4) abhängt.

5. Verfahren nach Anspruch 4, bei dem der Wert von n abhängig von einer Transformatorverschiebung des Transformators (4) gewählt wird.

6. Verfahren nach einem der Ansprüche 1 bis 5, bei dem zum Bestimmen eines Schätzwertes der Nullsystemspannung ($u^*_0$) und des Phasenwinkels ($\Phi^*_0$) des Nullsystems an der Oberspannungsseite anhand der gemessenen Dreiecksspannungen ($u_\Delta$) und Strangspannungen ($u_Y$) an der Unterspannungsseite eine qualitative Fehlerbestimmung vorgenommen wird, durch die auf das Vorliegen eines Fehler an einer Phase oder mehrerer der Phasen der Oberspannungsseite geschlossen werden kann und durch die ein Erdschluss einer der Phasen der Oberspannungsseite erkannt werden kann.

7. Verfahren nach Anspruch 6, bei dem zur qualitativen Fehlerbestimmung aus den gemessenen Dreiecksspannungen ($u_\Delta$) und Strangspannungen ($u_Y$) eine minimale Spannung ($V_{min}$) ermittelt wird, wobei ein Vergleich der gemessenen Dreiecksspannungen ($u_\Delta$) und Strangspannungen ($u_Y$) mit der minimalen Spannung ($V_{min}$) auf eine fehlerbehaftete Phase an der Oberspannungsseite schließen lässt.

8. Verfahren nach Anspruch 6 oder 7, bei dem zur qualitativen Fehlerbestimmung aus den gemessenen Dreiecksspannungen ($u_\Delta$) und Strangspannungen ($u_Y$) eine maximale Spannung ($V_{max}$) ermittelt wird, wobei ein Vergleich der maximalen Spannung ($V_{max}$) mit einem Vergleichswert, der charakteristisch ist für das oberspannungsseitige Netz, mit dem der Transformator (4) verbunden ist, auf einen Erdschluss an der Oberspannungsseite schließen lässt, wobei der Vergleichswert optional abhängig von einer subtransienten Kurzschlussleistung des Netzes ist.

9. Verfahren nach einem der Ansprüche 6 bis 8, bei dem als Ergebnis der qualitativen Fehlerbestimmung ermittelt wird, ob ein einpoliger oder ein zweipoliger Kurzschluss an der Oberspannungsseite vorliegt und/oder ob ein einpoliger oder ein zweipoliger Erdschluss vorliegt.

10. Verfahren nach Anspruch 9, bei dem beim Vorliegen eines einpoligen Erdschlusses der Wert für die Nullsystemspannung ($u^*_0$) an der Oberspannungsseite gleich dem Produkt der Gegensystemspannung u*- und der Wurzel der Mitsystemspannung u*+ gesetzt wird.

11. Verfahren nach Anspruch 9, bei dem beim Vorliegen eines zweipoligen Kurzschlusses der Wert für die Nullsystemspannung ($u^*_0$) an der Oberspannungsseite gleich null gesetzt wird.

12. Verfahren nach Anspruch 9, bei dem beim Vorliegen eines zweipoligen Erdschlusses der Wert für die Nullsystemspannung ($u^*_0$) an der Oberspannungsseite gleich dem Quotienten des Quadrats der Gegensystemspannung ($u^*-$) und der Mitsystemspannung ($u^*+$) gesetzt wird.

13. Verfahren nach Anspruch 9, bei dem der Wert für den Phasenwinkel ($\Phi^*_0$) im Nullsystem an der Oberspannungsseite gleich dem Phasenwinkel ($\Phi^*_-$) im Gegensystem an der Oberspannungsseite gesetzt wird, zuzüglich eines Phasenoffsets ($\Delta\Phi$), der 0°, 120° oder -120° beträgt, abhängig davon, auf welcher Phase an der Oberspannungsseite der qualitativ bestimmte Fehler vorliegt.

14. Vorrichtung zur näherungsweisen Bestimmung von Spannungen an einer Oberspannungsseite eines Transformators (4) anhand von gemessenen Spannungen an einer Unterspannungsseite des Transformators (4), **dadurch gekennzeichnet, dass** die Vorrichtung dazu eingerichtet ist, die folgenden Schritte durchzuführen:

- Messen von Dreiecksspannungen ($u_\Delta$) und Strangspannungen ($u_Y$) und Phasenwinkeln ($\Phi_Y$) an der Unterspannungsseite des Transformators (4);
- Transformieren der Strangspannungen ($u_Y$) und Phasenwinkel ($\Phi_Y$) in Mit- und Gegensystemspannungen ($u_+$, $u_-$) und Phasenwinkel ($\Phi_+$, $\Phi_-$) des Mit- bzw. Gegensystems an der Unterspannungsseite;
- Bestimmen von Mit- und Gegensystemspannungen ($u^*+$, $u^*_-$) und Phasenwinkeln ($\Phi^*_+$, ($\Phi^*_-$) des Mit- bzw. Gegensystems an der Oberspannungsseite aus den Mit- und Gegensystemspannungen ($u_+$, $u_-$) und Phasenwinkeln ($\Phi_+$, $\Phi_-$) des Mit- bzw. Gegensystems an der Unterspannungsseite;
- Bestimmen von Schätzwerten einer Nullsystemspannung ($u^*_0$) und eines Phasenwinkels ($\Phi^*_0$) eines Nullsystems an der Oberspannungsseite aus den gemessenen Dreiecksspannungen ($u_\Delta$) und Strangspannungen ($u_Y$) und Phasenwinkeln ($\Phi_Y$) an der Unterspannungsseite;
- Transformieren der Mit-, Gegen- und Nullsystemspannungen ($u^*_+$, $u^*_-$, $u^*_0$) und der Phasenwinkel ($\Phi^*_+$, $\Phi^*_-$, $\Phi^*_0$) in Strangspannungen und/oder Dreiecksspannungen an der Oberspannungsseite des Transformators (4).

15. Vorrichtung nach Anspruch 14, die in einen Wechselrichter (3) integriert ist.


**Claims**

1. A method for the approximate determination of voltages at a high voltage side of a transformer (4) on the basis of measured voltages at a low voltage side of the transformer (4), comprising the following steps:

- Measuring delta voltages (uo) and string voltages ($u_Y$) and phase angles ($\Phi_Y$) at the low voltage side of the transformer (4);
- Transforming the string voltages ($u_Y$) and phase angles ($\Phi_Y$) into positive and negative sequence voltages ($u_+$, $u_-$) and phase angles ($\Phi_+$, $\Phi_-$) of the positive and negative sequence systems, respectively, at the low voltage side;
- Determining positive and negative sequence voltages ($u^*+$, $u^*-$) and phase angles ($\Phi^*_+$, ($\Phi^*_-$) of the positive and negative sequence systems, respectively, at the high voltage side from the positive and negative sequence voltages ($u+$, $u-$) and phase angles ($\Phi_+$, $\Phi_-$) of the positive and negative sequence systems, respectively, at the low voltage side;
- Determining estimates of a zero-sequence voltage ($u^*_0$) and a phase angle ($\Phi^*_0$) of a zero-sequence system at the high voltage side from the measured delta voltages (uo) and string voltages ($u_Y$) and phase angles ($\Phi_Y$) at the low voltage side;
- Transforming the positive, negative and zero sequence voltages ($u^*+$, $u^*-$, $u^*_0$) and the phase angles ($\Phi^*_+$, $\Phi^*_-$) into string voltages and/or delta voltages at the high voltage side of the transformer (4).

2. The method of claim 1, wherein the positive and negative sequence voltages ($u^*_+$, $u^*_-$) at the high voltage side are set equal to the positive and negative sequence voltages ($u_+$, $u_-$) at the low voltage side.

3. The method of claim 2, wherein a correction value ($c_+$, $c_-$) is added to the positive and negative sequence voltages ($u_+$, $u_-$), respectively, to determine the positive and negative sequence voltages ($u^*_+$, $u^*_-$).

4. The method of any one of claims 1 to 3, wherein the phase angles ($\Phi^*_+$, ($\Phi^*_-$) of the positive- and negative-sequence systems, respectively, at the high voltage side are set from the phase angles ($\Phi_+$, $\Phi_-$) at the low voltage side, wherein a phase correction value is added that is n times 30° for the positive sequence system and n times -30° for the negative-sequence system, and wherein n is an integer value that depends on the type of transformer (4).

5. The method of claim 4, wherein the value of n is selected depending on a transformer shift of the transformer (4).

6. The method of any one of claims 1 to 5, wherein, to determine an estimate of the zero-sequence voltage ($u^*_0$) and the phase angle ($\Phi^*_0$) of the zero-sequence system at the high voltage side based on the measured delta voltages (uo) and string voltages ($u_Y$) at the low voltage side, a qualitative fault determination is made by which the presence of a fault on one or more of the phases of the high voltage side can be concluded and by which a ground fault of one of the phases of the high voltage side can be detected.

7. The method of claim 6, wherein a minimum voltage ($V_{min}$) is determined from the measured delta voltages (uo) and string voltages ($u_Y$) for the qualitative fault determination, wherein a comparison of the measured delta voltages ($u_\Delta$) and string voltages ($u_Y$) with the minimum voltage ($V_{min}$) indicates a faulty phase at the high voltage side.

8. The method of claim 6 or 7, wherein, for qualitative fault determination, a maximum voltage ($V_{max}$) is determined from the measured delta voltages (uo) and string voltages ($u_Y$), wherein a comparison of the maximum voltage ($V_{max}$) with a comparison value that is characteristic of the grid at the high voltage side to which the transformer (4) is connected indicates a ground fault at the high voltage side, wherein the comparison value is optionally dependent on a sub-transient short circuit power of the grid.

9. The method of any one of claims 6 to 8, wherein as a result of the qualitative fault determination it is determined whether a single-pole or a double-pole short circuit is present at the high voltage side and/or whether a single-pole or a double-pole ground fault is present.

10. The method of claim 9, wherein, in the presence of a single-pole ground fault, the value for the zero-sequence voltage ($u^*_0$) at the high voltage side is set equal to the product of the negative sequence voltage ($u^*_-$) and the square root of the positive sequence voltage ($u^*_+$).

11. The method of claim 9, wherein in the presence of a two-pole short circuit, the value for the zero-sequence voltage ($u^*_0$) at the high voltage side is set equal to zero.

12. The method of claim 9, wherein in the presence of a two-pole ground fault, the value for the zero-sequence voltage ($u^*_0$) at the high voltage side is set equal to the quotient of the square of the negative sequence voltage ($u^*_-$) and the positive sequence voltage ($u^*_+$).

13. The method of claim 0, wherein the value for the phase angle ($\Phi^*_0$) in the zero-sequence system at the high voltage side is set equal to the phase angle ($\Phi^*_-$) in the negative sequence system at the high voltage side, plus a phase offset ($\Delta\Phi$) that is 0°, 120°, or -120°, depending on which phase at the high voltage side the qualitatively determined fault is present.

14. A device for the approximate determination of voltages at a high voltage side of a transformer (4) on the basis of measured voltages at a low voltage side of the transformer (4), **characterized in that** the device is configured to perform the following steps:

- Measuring delta voltages (uo) and string voltages ($u_Y$) and phase angles ($\Phi_Y$) at the low voltage side of the transformer (4);

- Transforming the string voltages ($u_Y$) and phase angles ($\Phi_Y$) into positive and negative sequence voltages ($u_+$, $u_-$) and phase angles ($\Phi_+$, $\Phi_-$) of the positive and negative sequence systems, respectively, at the low voltage side;
- Determining positive and negative sequence voltages ($u^*_+$, $u^*_-$) and phase angles ($\Phi^*_+$, ($\Phi^*_-$) of the positive and negative sequence systems, respectively, at the high voltage side from the positive and negative sequence voltages (u+, u-) and phase angles ($\Phi_+$, $\Phi_-$) of the positive and negative sequence systems, respectively, at the low voltage side;
- Determining estimates of a zero-sequence voltage ($u^*_0$) and a phase angle ($\Phi^*_0$) of a zero-sequence system at the high voltage side from the measured delta voltages (uo) and string voltages ($u_Y$) and phase angles ($\Phi_Y$) at the low voltage side;
- Transforming the positive, negative and zero sequence voltages ($u^*_+$, $u^*_-$, $u^*_0$) and the phase angles ($\Phi^*_+$, $\Phi^*_-$) into string voltages and/or delta voltages at the high voltage side of the transformer (4).

15. The device of claim 14, integrated into an inverter (3).

**Revendications**

1. Procédé pour déterminer approximativement des tensions sur un côté haute tension d'un transformateur (4) à partir de tensions mesurées sur un côté basse tension du transformateur (4), comprenant les étapes suivantes :

- Mesure de tensions triangulaires (u et de tensions du string (uY) et d'angles de phase (Y) sur le côté basse tension du transformateur (4) ;
- Transformation des tensions du string (uY) et des angles de phase (Y) en tensions de co-système et de contre-système (u+, u-) et en angles de phase (+, -) du co-système et du contre-système du côté basse tension ;
- Détermination des tensions de co-système et de contre-système (u*+, u*-) et des angles de phase (+, -) du co-système et du contre-système du côté haute tension à partir des tensions de co-système et de contre-système (u+, u-) et des angles de phase (+, -) du co-système et du contre-système du côté basse tension ;
- Détermination des estimations d'une tension de système zéro (u*0) et d'un angle de phase (0) d'un système zéro du côté haute tension à partir des tensions triangulaires (u et tensions du string (uY) et des angles de phase (Y) mesurés du côté basse tension ;
- Transformation des tensions de co-système, de contre-système et de système zéro (u*+, u*-, u*0) et des angles de phase (+, -, 0) en tensions du string et/ou en tensions triangulaires du côté haute tension du transformateur (4).

2. Procédé selon la revendication 1, dans lequel les tensions de co-système et de contre-système (u*+, u*-) du côté haute tension sont définies comme étant égales aux tensions de co-système et de contre-système (u+, u-) du côté basse tension.

3. Procédé selon la revendication 2, dans lequel une valeur de correction (c-, c-) est ajoutée aux tensions de co-système ou de contre-système (u+, u-) pour déterminer les tensions de co-système et de contre-système (u*+, u*-).

4. Procédé selon l'une quelconque des revendications 1 à 3, dans lequel les angles de phase (+, -) du co-système et du contre-système respectivement du côté haute tension sont établis à partir des angles de phase (+, -) du côté basse tension, une valeur de correction de phase étant ajoutée, qui est égale à n fois 30° pour le co-système et à n fois -30° pour le contre-système, et n étant une valeur entière qui dépend du type de transformateur (4).

5. Procédé selon la revendication 4, dans lequel la valeur de n est choisie en fonction d'un déplacement du transformateur (4).

6. Procédé selon l'une quelconque des revendications 1 à 5, dans lequel, pour déterminer une estimation de la tension de système zéro (u*0) et de l'angle de phase (0) du système zéro du côté haute tension, on effectue, à partir des tensions triangulaires (u et des tensions du string (uY) mesurées du côté basse tension, une détermination qualitative de défaut qui permet de conclure à la présence d'un défaut sur une ou plusieurs des phases du côté haute tension et qui permet de détecter un défaut à la terre d'une des phases du côté haute tension.

7. Procédé selon la revendication 6, dans lequel une tension minimale (Vmin) est déterminée à partir des tensions triangulaires (u et des tensions du string (uY) mesurées pour la détermination qualitative du défaut, une comparaison des tensions triangulaires (u et des tensions du string (uY) mesurées avec la tension minimale (Vmin) permettant de conclure à une phase défectueuse du côté haute tension.

8. Procédé selon la revendication 6 ou 7, dans lequel, pour la détermination qualitative du défaut, une tension maximale (Vmax) est déterminée à partir des tensions triangulaires (u et des tensions du string (uY) mesurées, une comparaison de la tension maximale (Vmax) avec une valeur de comparaison, qui est caractéristique du réseau côté haute tension, auquel le transformateur (4) est relié, permettant de conclure à un défaut à la terre sur le côté haute tension, la valeur de comparaison dépendant éventuellement d'une puissance de court-circuit subtransitive du réseau.

9. Procédé selon l'une des revendications 6 à 8, dans lequel on détermine, comme résultat de la détermination qualitative du défaut, s'il y a un court-circuit unipolaire ou bipolaire du côté haute tension et/ou s'il y a un défaut à la terre unipolaire ou bipolaire.

10. Procédé selon la revendication 9, dans lequel, en présence d'un court-circuit à la terre unipolaire, la valeur de la tension de système zéro (u*0) du côté haute tension est égale au produit de la tension de contre-système u*- et de la racine de la tension de co-système u*+.

11. Procédé selon la revendication 9, dans lequel, en présence d'un court-circuit bipolaire, la valeur de la tension de système zéro (u*0) du côté haute tension est fixée à zéro.

12. Procédé selon la revendication 9, dans lequel, en présence d'un court-circuit bipolaire à la terre, la valeur de la tension de système zéro (u*0) du côté haute tension est égale au quotient du carré de la tension de contre-système (u*-) et de la tension de co-système (u*+).

13. Procédé selon la revendication 9, dans lequel la valeur de l'angle de phase (0) dans le système zéro du côté haute tension est égale à l'angle de phase (-) dans le contre-système du côté haute tension, en plus d'un décalage de phase () qui est de 0°, 120° ou -120°, selon la phase du côté haute tension sur laquelle l'erreur déterminée qualitativement est présente.

14. Dispositif pour déterminer approximativement des tensions sur un côté haute tension d'un transformateur (4) à partir de tensions mesurées sur un côté basse tension du transformateur (4), **caractérisé en ce que** le dispositif est agencé pour effectuer les étapes suivantes :

   - Mesure de tensions triangulaires (u et de tensions du string (uY) et d'angles de phase (Y) sur le côté basse tension du transformateur (4) ;
   - Transformation des tensions du string (uY) et des angles de phase (Y) en tensions de co-système et de contre-système (u+, u-) et en angles de phase (+, -) du co-système et du contre-système du côté basse tension ;
   - Détermination des tensions de co-système et de contre-système (u*+, u*-) et des angles de phase (+, -) du co-système et du contre-système du côté haute tension à partir des tensions de co-système et de contre-système (u+, u-) et des angles de phase (+, -) du co-système et du contre-système du côté basse tension ;
- Détermination des estimations d'une tension de système zéro (u∗0) et d'un angle de phase (0) d'un système zéro du côté haute tension à partir des tensions triangulaires (u et tensions du string (uY) et des angles de phase (Y) mesurés du côté basse tension ;
- Transformation des tensions de co-système, de contre-système et de système zéro (u∗+, u∗-, u∗0) et des angles de phase (+, -, 0) en tensions du string et/ou en tensions triangulaires du côté haute tension du transformateur (4).

15. Dispositif selon la revendication 14, qui est intégré dans un onduleur (3).

Fig. 1

## Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8949054 B2

**In der Beschreibung aufgeführte Nicht-Patentliteratur**

- **BOLLEN ; STYVAKTAKIS.** Characterization of Three-Phase Unbalanced Dips. *IEEE, 2000 Power Engineering Society Summer Meeting (Cat. No.00CH37134), Seattle, WA,* 2000, vol. 2, 899-904

- **BOLLEN ; STYVAKTAKIS.** *IEEE, 2000 Power Engineering Society Summer Meeting (Cat. No.00CH37134), Seattle, WA,* 2000, vol. 2, 899-904